(19)

Europäisches
Patentamt
European
Patent Office
Office européen
des brevets

(11) **EP 2 395 548 A1**

(12) **EUROPEAN PATENT APPLICATION**

(43) Date of publication:
**14.12.2011 Bulletin 2011/50**

(51) Int Cl.:
**H01L 23/367** (2006.01)

(21) Application number: **10251057.5**

(22) Date of filing: **08.06.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(71) Applicant: **NXP B.V.
5656 AG Eindhoven (NL)**

(72) Inventors:
• **Boezen, Henk
Redhill,
Surrey RH1 1DL (GB)**
• **Koops, Gerhard
Redhill,
Surrey RH1 1DL (GB)**

• **Golubovic, Dusan
Redhill,
Surrey RH1 1DL (GB)**
• **Krabbenborg, Benno
Redhill,
Surrey RH1 1DL (GB)**
• **Swanenberg, Maarten Jacobus
Redhill,
Surrey RH1 1DL (GB)**

(74) Representative: **Burton, Nick
NXP Semiconductors
IP&L Department
Betchworth House
57-65 Station Road
Redhill, Surrey RH1 1DL (GB)**

(54) **Silicon-on-insulator structure**

(57)    A silicon on insulator structure (SOI) comprising a base silicon layer, a silicon substrate and an insulating layer between the base silicon layer and the silicon substrate; and an active device formed in the silicon substrate, which active device comprises an active area, the structure further comprising a thermal conductor extending from the active area to the base silicon layer.

FIG. 1

EP 2 395 548 A1

## Description

This invention relates to a silicon-on-insulator (SOI) structure, and particularly, but not exclusively to a SOI structure for electronic circuits comprising power devices.

Semiconductor power devices can be made using bulk silicon technology or using SOI technologies, and both technologies have their advantages. An advantage of using SOI based technology is, in general, the better dielectric isolation between different transistors and the fact that there is less electromagnetic coupling (EMC) between the transistors.

As is known in the art an SOI structure comprises a base silicon layer, a silicon substrate, and an insulating layer sandwiched between the base silicon layer and the silicon substrate. The insulating layer is often described as a buried oxide layer since it is typically formed from silicon dioxide. However, the isolation layer could also be formed from any other insulating material such as silicon nitride or $Al_2O_3$.

SOI structures have many advantages over bulk silicon devices. For example, the buried oxide layer provides an insulation layer which results in a reduction of various adverse effects such as latch-up, and parasitic junction capacitance. In addition, SOI technology allows for excellent dielectric insulation between adjacent power devices formed on the same SOI substrate.

A problem with SOI based technologies stems from the fact that the buried oxide layer has a low thermal conductivity. Typically, silicon dioxide, which often forms the buried oxide layer, has a thermal conductivity value of between 0.4 to 1.2 $WK^{-1}m^{-1}$. Silicon, on the other hand has a thermal conductivity value of approximately 150 $WK^{-1}m^{-1}$. This means that heat generated from active devices formed on an SOI structure cannot be easily dissipated. This in turn leads to overheating of the active devices which can have a damaging effect on the performance of any such device.

This problem is especially acute for clamped inductive switching devices which may have power peaks that are in the region of a few 100 $\mu$s to 10 ms.

In certain areas of technology, for example within the automotive sector, it can be advantageous to integrate transceivers, for in-vehicle networks, with more functional devices such as power switches or relay drivers. Relay drivers may be regarded as relatively small power switches having a resistance of approximately 1 ohm that have to switch inductive loads.

The current through an inductor cannot be switched off without causing an inductive voltage over the switch. This inductive voltage $V_L$ is given by:

$$V_L = L \cdot \frac{dI}{dt} \quad (1)$$

where L is the inductance of the load and I is the current.

During the switching off cycle of the relay, the inductive voltage (back-emf) of the inductor needs to stay below the breakdown voltage of the transistor forming the power switch.

This may be achieved via so called "active-clamping" in which the power device is switched on when a predetermined threshold voltage is reached.

The current pulse during clamping switching may be given by

$$I(t) = I_o - (V_{Clamp} - V_{Bat}) \, t \, / \, L \quad (2)$$

Where $I_0$ is the initial current, $V_{Clamp}$ is the clamping (threshold) voltage, $V_{Bat}$ is the battery voltage and L is the inductance of the load.

A power pulse of this nature will create a significant amount of heat within a transistor forming the power device.

The insulating layer of the SOI structure has low thermal conductivity as explained herein above. This means that the heat created when a power device is switched using active clamping is not easily able to find a route to the silicon substrate which acts as a heat sink. This in turn means that such power devices are liable to heat up to undesirably high temperatures.

In order to overcome this problem it is known to over dimension active devices such as clamped inductive switching devices in order that the resulting structure may enable heat to be dissipated away from any active area.

However, this solution is not appropriate for many applications where the size of a particular integrated circuit may be important.

According to a first aspect of the invention there is provided a silicon on insulator structure (SOI) comprising a base silicon layer, a silicon substrate and an insulating layer between the base silicon layer and the silicon substrate, and an active device formed on the silicon substrate, which active device comprises an active area, the structure further comprising a thermal conductor extending from the active area to the base silicon layer.

The thermal conductor provides a connection between the active layer of the active device and the base silicon layer, thus allowing heat to dissipate effectively and efficiently from the power device.

The thermal conductor may comprise any suitable material having a high thermal conductivity, and may for example comprise polysilicon. Other materials with a higher thermal conductivity than silicon dioxide could also be used. In embodiments of the invention, the material which the thermal conductor is formed has a thermal conductivity that is at least 10 x greater than that of silicon dioxide.

The thermal conductor may take any appropriate form and may for example be in the form of a plug. The plug may have any suitable cross-sectional dimension. The cross-sectional dimension of the plug may be in the range, 200 nm to 2 $\mu$m. Typically this dimension will be 1 $\mu$m.

In embodiments of the invention the base silicon layer is connected to ground. In embodiments of the invention where the active device comprises a relay driver in the form of a low side driver, the source of the relay driver may also be connected to ground.

In such embodiments of the invention, the thermal conductor may extend from a source region of the power device to the silicon based layer. Because the source and the base silicon layer may be connected to ground, in normal operation of the SOI structure, both the source area and the base layer are connected. This means that the thermal conductor will have little if any effect on the electrical characteristics of the active device.

However, in other embodiments the position of the conductor may be different.

The insulating layer may comprise a buried oxide layer.

According to a second aspect of the present invention there is provided an integrated circuit comprising a silicon on insulator structure (SOI) comprising a base silicon layer, a silicon substrate and an insulating layer between the base silicon layer and the silicon substrate; and an active device formed in the silicon substrate, which active device comprises an active area, the structure further comprising a thermal conductor extending from the active area to the base silicon layer.

Features of the structure according to the first aspect of the invention may also be present in the integrated circuit forming the second aspect of the invention.

The invention will now be further described by way of example only with reference to the accompanying drawings in which:

Figure 1 is a schematic representation of a silicon on insulator structure according to an embodiment of the invention;

Figure 2 is a graphical representation showing the position of the thermal conductor forming part of the structure shown in Figure 1; and

Figure 3 is a graphical representation showing the transient temperature response of a clamped switching event for a device of the type shown in Figure 1 both with and without a thermal conductor forming part of the structure shown in Figure 1.

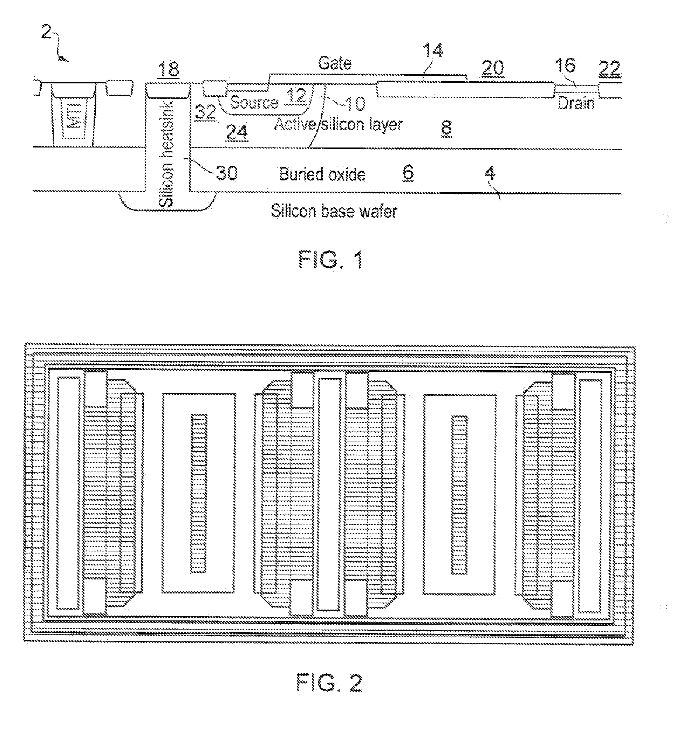

Referring to Figure 1, a silicon on insulator structure according to an embodiment of the invention is designated generally by the reference numeral 2. The structure 2 comprises a base silicon layer 4, an insulating layer 6 comprising a buried oxide layer, and a silicon substrate 8. The insulating layer 6 is sandwiched between the base layer 4 and the silicon substrate 8.

The structure 2 further comprises an active device 10 which in this example comprises a MOSFET transistor. The active device comprises an active area comprising a source 12, a gate 14 and a drain 16. In this embodiment the gate 14 comprises a layer of polysilicon. The source 12, gate 14 and drain 16 are each respectively connected to contacts 18, 20 and 22 formed from a metal layer. The device 10 further comprises a well region 24.

The structure 2 further comprises a thermal conductor 30 which extends from a source region 32 of the active device 10 to the base layer 4. By means of the thermal conductor 30 it is possible for heat generated by the active device to be efficiently dissipated since the thermal conductor 30 provides a route for heat to pass from the active device to the base silicon layer which acts as a heat sink.

In use, the base layer 4 is connected to ground. When the active device is a relay driver which will typically be a low side driver, the source 10 of the relay driver is also connected to ground. In such an embodiment, the thermal conductor will extend into the source region 32 of device 10 as shown in Figure 1. However, if the active device has some other configuration, then the thermal conductor 30 may be positioned in a different region of the active device.

Figure 2 shows the positioning of the thermal conductor 30 in the source area of the active device 10 shown in Figure 1.

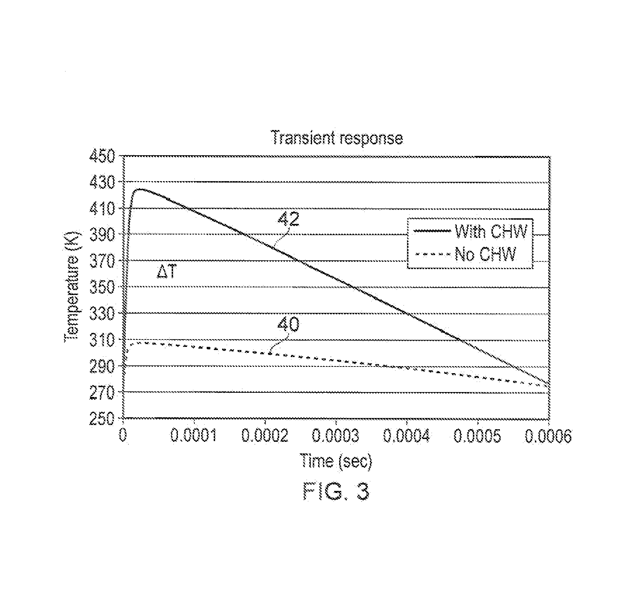

Figure 3 is a schematic representation showing the transient temperature response of a clamped switching event for the device shown in Figure 1 and for a similar known device not including a thermal conductor 30. The curve 40 represents the transient temperature response of the structure 2 shown in Figure 1, and the curve 42 represents the transient temperature response of the a known similar structure that does not incorporate a thermal conductor 30 in accordance with the invention.

In the known device, the surface temperature of the structure may reach approximately 420 K. In contrast, the maximum surface temperature of the device shown in Figure 1 reaches only approximately 300 K.

The structure 2 may be formed using any suitable fabrication methods. In particular, the structure may be made advanced BCD technologies.

**EP 2 395 548 A1**

## Claims

1. A silicon on insulator structure (SOI) (2) comprising a base silicon layer (4), a silicon substrate (8) and an insulating layer (6) between the base silicon layer and the silicon substrate; and an active device (10) formed in the silicon substrate, which active device comprises an active area (12, 14, 16), the structure further comprising a thermal conductor (30) extending from the active area to the base silicon layer (4).

2. A structure (2) according to Claim 1 wherein the thermal conductor (30) comprises a material having a thermal conductivity that is at least 10 times greater than that of silicon dioxide.

3. A structure (2) according to Claim 1 or Claim 2 wherein the thermal conductor (30) comprises polysilicon.

4. A structure (2) according to any one of the preceding claims wherein the cross-sectional dimension of the conductor (30) is in the range 200 nm to 2 $\mu$m.

5. A structure (2) according to any one of the preceding claims wherein the thermal conductor (30) is in the form of a plug.

6. A structure (2) according to any one of the preceding claims wherein the active device (10) comprises a source (12), and the source of the active device and the base silicon layer (4) are connected to ground.

7. A structure (2) according to any one of the preceding claims wherein the insulating layer comprises a buried oxide layer.

8. An integrated circuit comprising a silicon on insulator structure (SOI) (2) according to any one of the preceding claims.

FIG. 1

FIG. 2

FIG. 3

Europäisches Patentamt
European Patent Office
Office européen des brevets

# EUROPEAN SEARCH REPORT

Application Number

EP 10 25 1057

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/232554 A1 (HIRANO YUUICHI [JP] ET AL) 25 November 2004 (2004-11-25) | 1,2,5-8 | INV. H01L23/367 |
| Y | * figure 1 * <br> * paragraph [0031] - paragraph [0033] * <br> ----- | 3,4 | |
| X | US 5 366 923 A (BEYER KLAUS D [US] ET AL) 22 November 1994 (1994-11-22) | 1-3,5,7,8 | |
| Y | * figure 10 * <br> * column 1, line 22 - line 25 * <br> * column 3, line 46 - column 4, line 62 * <br> * column 5, line 16 - line 20 * <br> * column 6, line 59 - column 8, line 40 * <br> ----- | 4,6 | |
| X | US 6 121 661 A (ASSADERAGHI FARIBORZ [US] ET AL) 19 September 2000 (2000-09-19) | 1-3,5,7,8 | |
| Y | * figures 3B, 4A, 5D * <br> * column 3, line 37 - line 41 * <br> * column 3, line 62 - column 4, line 61 * <br> ----- | 4,6 | |
| X | US 2004/084726 A1 (KIM SANG GI [KR] ET AL KIM SANG GI [KR] ET AL) 6 May 2004 (2004-05-06) | 1-3,5,7,8 | TECHNICAL FIELDS SEARCHED (IPC) |
| Y | * figures 2, 3 * <br> * paragraph [0019] - paragraph [0021] * <br> ----- | 4,6 | H01L |
| X | FR 2 901 407 A1 (COMMISSARIAT ENERGIE ATOMIQUE [FR]) 23 November 2007 (2007-11-23) | 1,2,5,7,8 | |
| Y | * figure 3A * <br> * page 7, line 1 - page 8, line 19 * <br> ----- | 3,4,6 | |
| X | US 6 573 565 B2 (CLEVENGER LAWRENCE A [US] ET AL CLEVENGER LAWRENCE A [US] ET AL) 3 June 2003 (2003-06-03) | 1,2,5,7,8 | |
| Y | * figures 2, 7E, 7F * <br> * table 1 * <br> * column 5, line 7 - line 30 * <br> * column 7, line 54 - line 65 * <br> ----- | 3,4,6 | |

The present search report has been drawn up for all claims

| Place of search | Date of completion of the search | Examiner |
|---|---|---|
| The Hague | 29 October 2010 | Hofer, Christiane |

EPO FORM 1503 03.82 (P04C01)

**ANNEX TO THE EUROPEAN SEARCH REPORT
ON EUROPEAN PATENT APPLICATION NO.**

EP 10 25 1057

This annex lists the patent family members relating to the patent documents cited in the above-mentioned European search report.
The members are as contained in the European Patent Office EDP file on
The European Patent Office is in no way liable for these particulars which are merely given for the purpose of information.

29-10-2010

| Patent document cited in search report | | Publication date | Patent family member(s) | | Publication date |
|---|---|---|---|---|---|
| US 2004232554 | A1 | 25-11-2004 | JP 2004349537 A<br>US 2007007595 A1 | | 09-12-2004<br>11-01-2007 |
| US 5366923 | A | 22-11-1994 | EP 0570321 A2<br>JP 2059296 C<br>JP 6132184 A<br>JP 7099729 B<br>US 5276338 A | | 18-11-1993<br>10-06-1996<br>13-05-1994<br>25-10-1995<br>04-01-1994 |
| US 6121661 | A | 19-09-2000 | US 6352882 B1 | | 05-03-2002 |
| US 2004084726 | A1 | 06-05-2004 | KR 20040038507 A | | 08-05-2004 |
| FR 2901407 | A1 | 23-11-2007 | NONE | | |
| US 6573565 | B2 | 03-06-2003 | US 2002113288 A1<br>US 2003189231 A1 | | 22-08-2002<br>09-10-2003 |

EPO FORM P0459

For more details about this annex : see Official Journal of the European Patent Office, No. 12/82